**Europäisches Patentamt**

**European Patent Office**

**Office européen des brevets**

(19)

(11) Veröffentlichungsnummer: **0 182 195**
A2

# (12) EUROPÄISCHE PATENTANMELDUNG

(21) Anmeldenummer: **85114078.0**

(22) Anmeldetag: **05.11.85**

(51) Int. Cl.⁴: **B 41 C 1/14,** G 03 F 7/12, C 25 D 7/00

(30) Priorität: **14.11.84 DE 3441593**

(43) Veröffentlichungstag der Anmeldung: **28.05.86** Patentblatt 86/22

(84) Benannte Vertragsstaaten: **BE CH FR GB IT LI NL SE**

(71) Anmelder: **Ferd. Rüesch AG., Spitalgasse 8, CH-9004 St. Gallen (CH)**

(72) Erfinder: **Keller, Heinz, Aetschbergstrasse 20 a, CH-9014 St. Gallen (CH)**
Erfinder: **Brocker, Heinz, Boecklinstrasse 55, CH-9000 St. Gallen (CH)**
Erfinder: **Lehner, Martin, Ringelbergstrasse 4, CH-9000 St. Gallen (CH)**

(74) Vertreter: **Federhen, Ludwig, Dr., Kronprinzstrasse 14, D-7000 Stuttgart 1 (DE)**

(54) **Verfahren und Vorrichtung zum Herstellen von Siebdruckgeweben für Siebdruckzylinder.**

(57) Nach dem erfindungsgemäßen Verfahren wird Chromstahlgewebe in Leinenbindung mit vorzugsweise einer Mesh-Zahl von 250 bis 500 und einer Drahtstärke von 5 bis 10 my kontinuierlich elektrolytisch oder chemisch in einer Dicke von 2 bis 20 my mit Nickel beschichtet und das so versteifte Gewebe kontinuierlich mit einer einseitig ebenen Schicht einer lichtempfindlichen Emulsion oder Lösung versehen, indem zur Bildung der ebenen Schicht die lichtempfindliche Emulsion oder Lösung auf eine ebene, beheizte, bewegte Fläche aufgetragen wird und während des Trocknungsvorganges der Schicht die vernickelte Chromstahlgewebebahn auf die Rückseite der Schicht geführt und durch Aufbringen einer weiteren Emulsionsschicht mit der gebildeten ebenen Schicht verbunden wird. Als Vorrichtungen werden zum Vernickeln mehrere Tauchbäder zum Reinigen und Entfetten der Chromstahlgewebebahn und vorzugsweise eine negativ gepolte Kontaktwalze und ein elektrolytisches Tauchbad mit einem in das Bad eintauchenden, nicht leitenden Zylinder verwendet, über den die Chromstahlgewebebahn zum kontinuierlichen Vernickeln geführt wird. Zum Herstellen der ebenen Schicht aus lichtempfindlichem Material wird eine aus einem oder mehreren geheizten, mit Auftragsvorrichtungen und Zuführvorrichtungen für die Chromstahlgewebebahn versehenen Zylindern bestehende Vorrichtung verwendet.

Ferd. Rüesch AG
St. Gallen/Schweiz

<u>Verfahren und Vorrichtung zum Herstellen von
Siebdruckgeweben für Siebdruckzylinder.</u>

Die Erfindung hat ein Verfahren und Vorrichtungen
zum kontinuierlichen Herstellen von fotochemisch
beschichteten Siebdruckgeweben zum Gegenstand, aus
denen Siebdruckzylinder zum rotativen Siebdrucken
hergestellt werden können.
Das klassische Siebdruckverfahren ist ein intermittierendes Verfahren, bei dem ein in einen Rahmen eingespanntes Sieb auf die stillstehende, zu
bedruckende Fläche abgesenkt und die Farbe mittels
einer auf dem Sieb hin und her bewegten Rakel
durch die nicht durch das negative Druckbild abgedeckten Öffnungen des Siebes gestrichen und auf
die zu bedruckende Fläche aufgetragen wird. Dabei
besteht das Sieb aus einem mehr oder weniger flexiblen Gewebe, das durch den Rahmen in einem Spannungszustand gehalten wird.
Das klassische Siebdruckverfahren ist zur Verwendung in schnell laufenden und demzufolge rotativen
Druckmaschinen, die mit mehreren Druckwerken unterschiedlicher Druckverfahren und möglicherweise
anderen Bearbeitungsstationen versehen sind, wegen
des intermittierenden Verfahrens ungeeignet, da es
eine Umstellung des rotativen Verfahrens in ein
intermittierendes Verfahren erfordert. Es ist deshalb vorgeschlagen worden, Siebdruckverfahren mit tels rotierenden Siebdruckzylindern mit feststehender Rakel im Inneren des Zylinders zu entwikkeln. Dabei stellte sich jedoch das Problem der Herstellung von stabilen, verwindungsfreien Zylindern aus einem notwendigerweise aus einem Gewebe bestehenden Material, das selbst keine oder nur geringe Festigkeit zum Abrollen eines daraus geformten Zylindermantels auf einem Gegendruckzylinder besitzt, und das durch das Auftragen einer lichtempfindlichen Schicht nicht wesentlich verfestigt werden kann bzw. nach dem Auswaschen der nicht belichteten Flächen wieder an Festigkeit verliert.

Es ist deshalb in der DE-OS 2728084 vorgeschlagen worden, auf einen aus einem metallischen Gewebe bestehenden Stützmantel grosser Maschenweite einen nichtmetallischen Gazeschlauch aufzuschrumpfen und auf elektrolytischem Wege darauf zu befestigen und sodann die Oberfläche des Gazeschlauches mit einer Kopierschicht zu versehen. Dieses Verfahren hat jedoch den Nachteil der Einzelherstellung.

Ein weiterer auch durch das vorbezeichnete Verfahren nicht überwundener Nachteil der bekannten Beschichtungen von Siebdruckgeweben besteht darin, dass keine ebene Schichtoberfläche auf dem unregelmässigen Gewebe erzielt werden kann. Bei dem Beschichten des Gewebes und dem anschliessenden Trocknen der Kopierschicht sinkt die lichtempfindliche Emulsion oder Lösung in die Öffnungen des Gewebes ein, sodass keine ebene und gleichmässig dicke Kopierschicht entsteht. Dieser allen Siebbeschichtungsverfahren immanente Nachteil kann auch nicht durch die Verwendung thixotroper Emulsionen vermieden werden wie dies von Kyle, Der Siebdruck, Nr. 8/84, vorgeschlagen wurde, da bei zu geringer Thixotropität ein Einsinken der Emulsion nach wie vor stattfindet, bei zu grosser Thixotropität jedoch eine einwandfreie Entgasung des Gewebes nicht möglich ist.

Aus der US-PS 3.759.799 ist ein Verfahren zum Herstellen von Siebdruckzylindern, die aus einem zwischen Endscheiben befestigten Stahlgewebe bestehen, bekannt, durch das die vorgenannten Nachteile überwunden werden sollen. Nach diesem Verfahren wird zunächst eine Gewebefläche aus rostfreiem Stahldraht mit einer für die Dicke des Siebdrucks vorbestimmten Maschenweite vor einer als Kathode dienenden Platte aus poliertem, rostfreiem Stahl angeordnet und sodann die Fläche mit dem davor angeordneten Gewebe elektrolytisch vernickelt. Nach dem Vernickeln wird die Gewebefläche, die nunmehr mit einer auf der Kathode gebildeten Nikkelfolie verbunden ist, von der polierten Stahlfläche abgezogen, die Folienseite des Gewebes mit einer fotochemischen Schicht eben beschichtet, mit dem Druckbild belichtet und entwickelt. Nach dem Auswaschen der unbelichteten Flächen werden nunmehr die offenliegenden Flächen die Nickelfolie ausgeätzt, bis das Stahlgewebe freiliegt.

Das bekannte Verfahren hat nicht nur den Nachteil, dass eine Vielzahl von Verfahrensschritten notwendig sind und die Siebschablonen nur einzeln hergestellt werden können, sondern vor allem den Nachteil, dass durch das Ausätzen der Nickelbeschichtung nicht nur die Festigkeit der Siebdruckfläche wieder geschwächt werden kann, sondern dass auch die durch die Vernickelung erzielte Verfestigung der Kreuzungspunkte des Stahlgewebes weggeätzt werden kann. Nachteilig ist vor allem, dass die Ätzung grösste Genauigkeit hinsichtlich der Konzentration des Ätzmittels und der Dauer der Ätzung erfordert, die nur durch sehr qualifizierte Fachleute erzielt werden kann.

Der Erfindung liegt einerseits die Aufgabe zugrunde, ein Verfahren zum Herstellen von fotochemisch beschichtetem Material für die Herstellung von Siebdruckzylindern zu finden, die nicht nur die Nachteile der bekannten Verfahren überwinden, sondern auch die kontinuierliche Herstellung derartigen Materials gestatten.

Die Lösung der Aufgabe wird in einem Verfahren gesehen, durch das ein Chromstahldrahtgewebe mit geeigneter Maschenweite mit Nickel lediglich elektrolytisch, chemisch oder durch Vakuumbedampfung soweit beschichtet wird, dass die Kreuzungspunkte des Gewebes verschiebungsfrei befestigt sind, und das verfestigte Material sodann mit einer oder mehreren Schichten mit lichtempfindlicher Emulsion oder Lösung durch Auftragen der Emulsion oder Lösung auf einer ebenen Oberfläche und Einbetten des Gewebes in die Rückseite der Emulsions- oder Lösungsschicht sowie deren Verbindung durch Auftragen einer weiteren Emulsionsschicht so beschichtet wird, dass eine ebene Kopierschicht auf der druckseitigen Oberfläche der Siebschablone entsteht. Dadurch wird ein Material erzielt, das auch nach dem Entwickeln und Auswaschen der nicht belichteten Flächen seine zum Herstellen eines Siebdruckzylinders notwendige Festigkeit behält, gleichzeitig aber eine nach der Beschichtung und Trocknung der Kopierschicht ebene Druckfläche aufweist, die ein Unterlaufen der Druckfläche durch Farbe verhindert und ein Drucken mit hoher Auflösung gestattet. Mit derartigen Schablonen und daraus geformten Siebdruckzylindern lassen sich Rasterdrucke in einer Feinheit erzielen, die bisher allein durch die Dehnung des Drucksiebes durch die Rakelbewegung und die damit verbundene Verschiebung der Sieböffnungen nicht erreicht werden konnten.

Die Verfestigung des Gewebes wird vorzugsweise durch elektrolytisches Beschichten mit Nickel vorgenommen, wobei das Chromstahldrahtgewebe in Bahnform endlos kontinuierlich durch ein elektrolytisches Tauchbad geführt wird, in dem die Gewebebahn direkt als Kathode dient.

Vorzugsweise wird ein Chromstahldrahtgewebe in Leinenbindung mit einer Mesh-Zahl von 250 bis 500 und einer Drahtstärke von 5 bis 50 my verwendet.

Vorzugsweise wird auf das Chromstahldrahtgewebe eine Nickelschicht von 2 bis 20 my aufgebracht.

Durch eine mehr oder weniger lange, über die zur Verfestigung notwendige Vernickelung der Gewebebahn hinausgehende Vernickelung des Gewebes kann die für die Menge der Farbauftragung wesentliche Maschenweite dadurch beeinflusst werden, dass die Stahldrähte des Chromstahlgewebes mit einer vorbestimmten, die Maschenweite einschränkenden Nickelschicht beschichtet werden. Dadurch wird vermie –

den, für verschieden dicke Farbauftragungen von vorneherein Gewebe mit verschiedener Maschenweite zu verwenden. Ferner lässt sich unter Verwendung feinsten Materials, dessen Maschenweite beim Weben nicht mehr verkleinert werden kann, eine weitere Verringerung der Maschenweite erzielen, ohne Material verwenden zu müssen, dessen ursprüngliche Festigkeit bereits durch den geringen Durchmesser der verwendeten Stahldrähte beeinträchtigt ist.

Im weiteren Zuge des Verfahrens wird die vernikkelte Chromstahlgewebebahn kontinuierlich mit einer oder mehreren Schichten einer lichtempfindlichen Emulsion oder Lösung so beschichtet, dass sich eine ebene Kopierschicht bildet.

Vorzugsweise wird zur Bildung einer ebenen Kopierschicht die lichtempfindliche Emulsion oder Lösung auf eine ebene, bewegte, geheizte Fläche aufgetragen und während des Trocknungsvorganges der Emulsion oder Lösung die vernickelte Chromstahlgewebebahn auf die Rückseite der sich bildenden Kopierschicht geführt und durch Aufbringen einer weiteren Emulsions- oder Lösungsschicht mit der Kopierschicht verbunden.

Dieses Verfahren ist besonders für dicke Kopierschichten geeignet, wobei es von Vorteil ist, die Rückseite der Chromstahlgewebebahn und die darauf befindliche Schicht durch geeignete Mittel zu glätten, um eine erschütterungsfreie Rakelführung zu ermöglichen und die Rakelabnutzung zu vermindern.

Vorzugsweise kann die zweite Emulsions- oder Lösungsschicht während dem Zuführen der Chromstahlgewebebahn zwischen der Gewebebahn und der ersten Beschichtung vorgenommen werden. Dadurch wird von
der auflaufenden Chromstahlgewebebahn die Emulsion
oder Lösung durch die Sieböffnungen nach aussen
gepresst und das Gewebe entgast und die Bildung
von Bläschen oder Linsen verhindert.
Für sehr dünne Kopierschichten ist es dagegen von
Vorteil, anstelle einer zweiten Beschichtung die
angetrocknete erste Kopierschicht lediglich mit
Wasser oder Lösungsmittel so zu benetzen, dass die
Chromstahlgewebebahn sich ausreichend mit der Kopierschicht verbinden kann.
Um die Gefahr mangelhafter Ablösung der Kopierschicht von der ebenen geheizten Fläche zu verhindern, falls diese nicht ausreichend poliert ist,
hat es sich als vorteilhaft erwiesen, zur Bildung
der Kopierschicht lichtempfindliche Emulsion oder
Lösung auf eine Schutzfolie, vorzugsweise aus Polyester, aufzutragen, die über die ebene, geheizte
Fläche geführt wird. Die Schutzfolie kann nach dem
Austrocknen des beschichteten Siebdruckgewebes
abgezogen werden. Vorzugsweise verbleibt jedoch
die Schutzfolie solange auf der Kopierschicht, bis
diese belichtet wird, da die Kopierschicht durch
die Folie vor mechanischen oder chemischen Beschädigungen geschützt wird.
Es können auch handelsübliche Kopierschichten, die
auf einer Folie aufgebracht sind, verwendet werden. In diesem Falle wird zum Verbinden der Kopierschicht mit der Chromstahlgewebebahn die Rückseite der Kopierschicht durch Benetzen aktiviert
oder eine Emulsions- oder Lösungsschicht aufgetragen.
Das so gewonnene, mit einer lichtempfindlichen Schicht versehene bahnförmige Material kann anschliessend blattweise geschnitten und lichtundurchlässig verpackt und gelagert werden. Nach entsprechender Belichtung mit dem vorgesehenen Druckbild, dem Entwickeln und Auswaschen lässt sich das Material zu Zylindermänteln formen, aus den unter Verwendung von Endscheiben Siebdruckzylinder hergestellt werden können.

Der Erfindung liegt die weitere Aufgabe zugrunde, Vorrichtungen zum Verfestigen durch Vernickelung und Beschichten des verfestigten bahnförmigen Gewebes zu finden.

Die Vorrichtung zum kontinuierlichen Vernickeln besteht aus einer Anzahl von Tauchbädern zum Reinigen und Entfetten der Chromstahlgewebebahn und einem elektrolytischen Tauchbad für die Vernickelung, durch die die Gewebebahn kontinuierlich über Walzen geführt wird. In dem elektrolytischen Tauchbad ist ein bis zur Hälfte in das Bad eintauchender Zylinder mit nicht leitender Oberfläche angeordnet. Vor dem Zylinder ist eine negativ gepolte elektrische Kontaktwalze angeordnet, über die die von der im elektrolytischen Tauchbad von der darin angeordneten Anode ausgehenden und durch die Gewebebahn geleiteten elektrischen Ströme abgeleitet werden.

Der Zylinder hat vorzugsweise einen möglichst grossen Durchmesser, ist vertikal verschiebbar und weist eine polierte Oberfläche auf.

Durch den grossen Durchmesser und damit den grossen Umfang des Zylinders wird erreicht, dass die Chromstahlgewebebahn während des Vernickelungsvor-

Seite 9
0182195

ganges vollständig abgestützt wird. Damit werden
die bei freier Führung der Gewebebahn nicht zu
vermeidenden Wellenbildungen und deren Verfestigung vermieden.
Durch die vertikale Verschiebbarkeit des Zylinders
lässt sich ohne eine Änderung der Geschwindigkeit
der kontinuierlichen Vernickelungsanlage die Verweildauer der Chromstahlgewebebahn im Tauchbad
verändern.
Durch die polierte Oberfläche des nicht leitenden
Zylinders wird erreicht, dass die Vernickelung auf
der Rückseite der Chromstahlgewebebahn im Bereich
der Drähte etwas abgeflacht ist. Diese Abflachung
ist für einen glatteren, erschütterungsfreien Lauf
der Rakel im fertigen Siebdruckzylinder von Vorteil.
Ferner ist vor dem Tauchbad eine Breitstreckvorrichtung, vorzugsweise in Form einer bombierten
Walze angeordnet, um das vor der Vernickelung
leicht verschiebbare Gewebe möglichst gestreckt
auf den Zylinder des Tauchbades zu führen.

Die Beschichtungsvorrichtung zum Herstellen der
Kopierschicht und dem Verbinden der Kopierschicht
mit der verfestigten Chromstahlgewebebahn besteht
aus einem oder mehreren beheizten Zylindern, einer
oder mehreren gegen den oder die beheizten Zylinder angeordneten Beschichtungsvorrichtungen, einer
Zuführwalze für die vernickelte Chromstahlgewebebahn und einem Vorschub zum Transport der Bahn um
den oder die Trocknungszylinder. Vorzugsweise wird
lediglich ein beheizter Zylinder grossen Umfanges
verwendet, um den eine Folienabrollvorrichtung, eine Beschichtungsvorrichtung, eine Zuführvorrichtung, eine weitere Beschichtungsvorrichtung und eine Abzugsvorrichtung angeordnet sind.

Die zweite Beschichtungsvorrichtung ist vorzugsweise in einem Abstand von der ersten Beschichtungsvorrichtung angeordnet, der das Antrocknen der ersten Schicht auf dem Umfangsabschnitt des Zylinders erlaubt.

Vor allem bei Geweben mit geringer Maschenweite hat es sich als vorteilhaft erwiesen, die zweite Beschichtungsvorrichtung unmittelbar vor der Zuführungsvorrichtung für die vernickelte Chromstahlgewebebahn anzuordnen, um eine einwandfreie Gewebeentgasung zu erzielen.

Hinter der Zuführvorrichtung kann eine Kalandrierwalze angeordnet werden, um die Rückseite der Kopierschicht zusätzlich zu glätten.

Für sehr dünne Kopierschichten ist es vorteilhaft, anstelle einer zweiten Beschichtung die Kopierschicht lediglich über eine Benetzungsvorrichtung so zu aktivieren, dass eine ausreichende Verbindung mit der Chromstahlgewebebahn erzielt werden kann.

Auf die Zuführung einer Polyesterfolie kann verzichtet werden, wenn der oder die Trockenzylinder derartig poliert sind, dass sich der Verbund aus vernickelter Gewebebahn und getrockneter lichtempfindlicher Emulsion oder Lösung von dem Trockenzylinder abziehen lässt.

Die Vorrichtung hat den Vorteil, dass durch das Herstellen einer absolut planen Kopierschicht auf dem Trocknungszylinder eine einwandfreie Druckbildübertragung möglich ist.

Seite 11

0182195

Zur weiteren Erläuterung der Erfindung wird auf das in den beigefügten Zeichnungen dargestellte Ausführungsbeispiel der erfindungsgemässen Vorrichtungen verwiesen.

Es zeigen

Fig. 1 einen Schnitt durch eine mit einer Kopierschicht versehene Siebdruckschablone;

Fig. 2 einen Schnitt durch eine mit einer Kopierschicht versehene Siebdruckschablone gemäss der Erfindung;

Fig. 3 eine schematische Darstellung der Vernickelungsanlage;

Fig. 4 eine schematische Darstellung der Beschichtungsanlage;

Fig. 5 eine Ansicht auf der Linie A-A;

Fig. 6 eine Ansicht auf der Linie B-B;

Fig. 7 einen Schnitt durch die Bahn auf der Linie C-C.

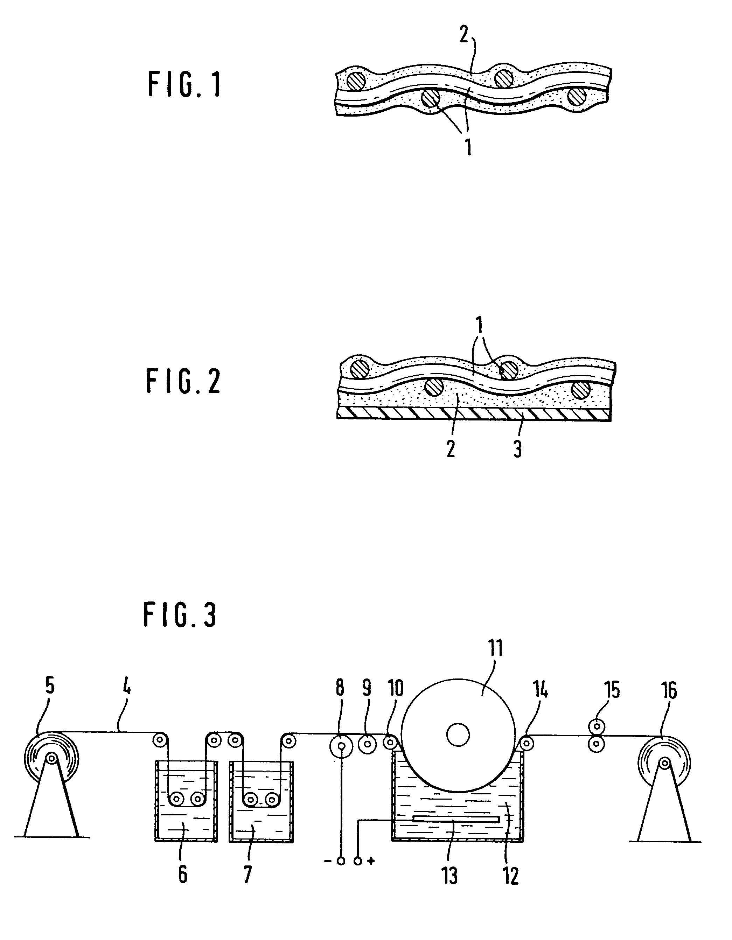

Die in Fig. 1 dargestellte Siebdruckschablone besteht aus dem Gewebe 1 und der Kopierschicht 2. Aus der Darstellung wird deutlich, dass an keiner der beiden Oberflächen eine das Unterlaufen der Druckfläche verhindernde, ebene Fläche vorhanden ist.

Die in Fig. 2 dargestellte Siebdruckschablone gemäss der Erfindung weist demgegenüber eine Schutzfolie 3 auf, auf der eben die Kopierschicht aufgetragen ist. Die Schutzfolie 3, die die Kopierschicht gegen mechanische und chemische Einflüsse schützt, wird erst unmittelbar vor dem Belichten der Kopierschicht entfernt.

Die in Fig. 3 schematisch dargestellte Vorrichtung

0182195

zum Vernickeln der aus einem Chromstahlgewebe mit einer Mesh-Zahl von 250 bis 500 my und einer Drahtstärke von 15 bis 30 my bestehenden Gewebebahn 4 besteht aus einer Abrollvorrichtung 5, beispielhaft dargestellten Reinigungs- und Vorbereitungsbädern 6,7, einer negativ gepolten Kontaktwalze 8, einer Breitstreckvorrichtung 9, hier in Gestalt einer bombierten Walze, einer Umlenkwalze 10 zum Einführen der Gewebebahn 4 in das elektrolytische Tauchbad 12, einer Abführwalze 14, einem Vorschub 15 und einer Aufrollvorrichtung 16. In dem Tauchbad 12 ist ein grosser Umlenkzylinder 11 angeordnet, dessen Oberfläche mit einer nicht leitenden polierten Schicht versehen ist. In dem Tauchbad 12 ist eine Anode 13 angeordnet.

Die Gewebebahn 4 wird nach dem Reinigen und Entfetten in den Tauchbädern 6, 7 über die Kontaktwalze 8 und die Breitstreckvorrichtung 9 mit der Führungswalze 10 an den Zylinder 11 in dem Tauchbad 12 geführt. Die Gewebebahn 4 ist die Kathode, auf der sich durch den Galvanisierungsvorgang die von der Anode 13 abgesonderten Nickel-Ionen absetzen und dort je nach der Verweildauer der Gewebebahn 4 im Tauchbad 12 und den sonstigen Galvanisierungsparametern eine mit Ausnahme der Rückseite der auf dem Zylinder aufliegenden Drähte des Gewebes gleichmässige Beschichtung des Gewebes mit einer 5 bis 20 my dicken Nickelschicht bilden. Die Gewebebahn 4 wird von dem Vorschub 15 über die Abführwalze 14 aus dem Tauchbad 12 gezogen und nach dem Trocknen und eventuell notwendigen Nachbehandeln auf der Aufrollvorrichtung 16 aufgerollt.

0182195

Die Gewebebahn 4 aus einem in Leinenbindung gewebten Chromstahlgewebe ist durch die Vernickelung
derart verfestigt, dass sie den Anforderungen hinsichtlich der Stabilität als Siebdruckzylinder und
dessen statisch-dynamischer Beanspruchung genügt.

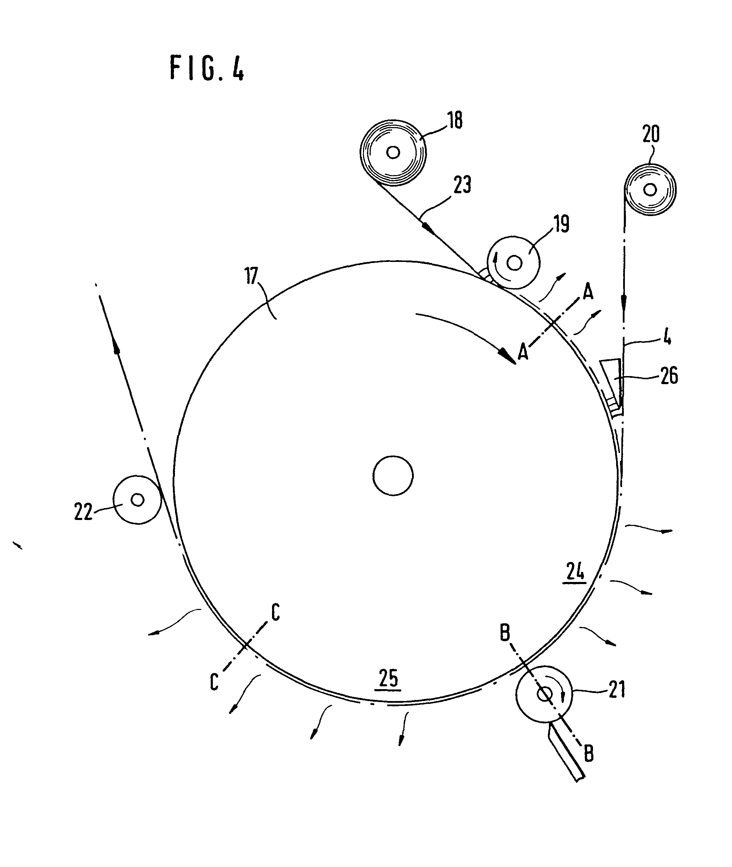

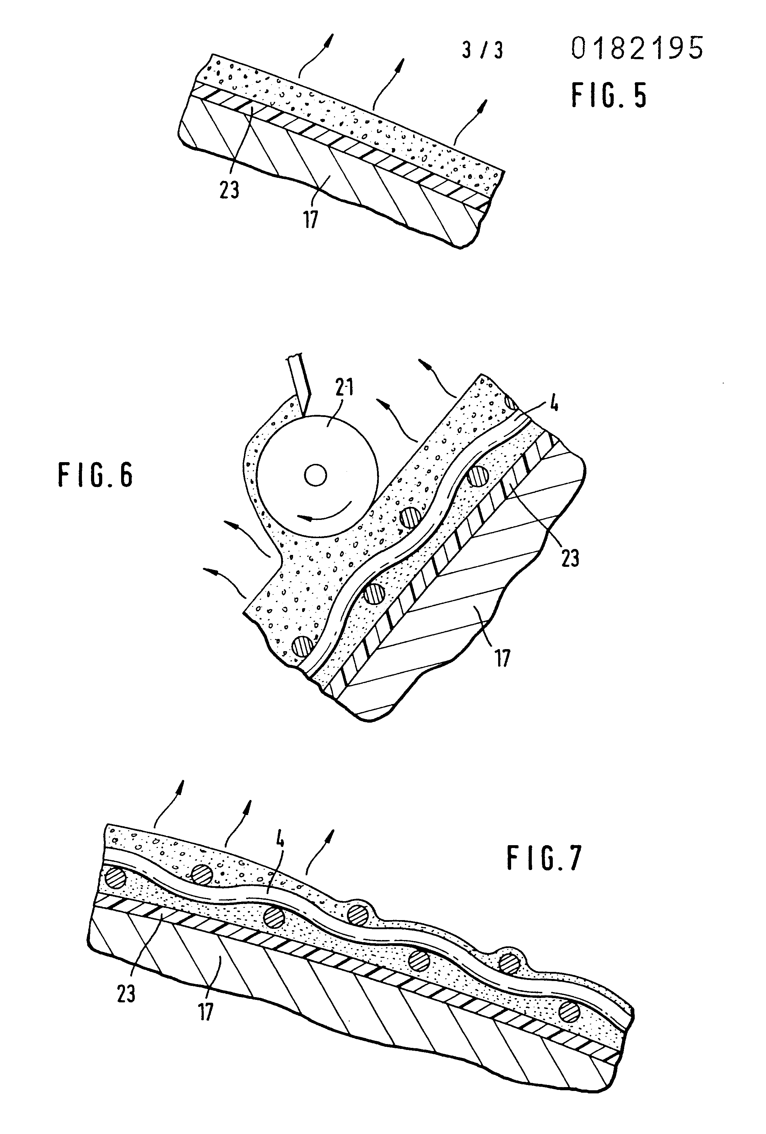

Die in Fig. 4 schematisch dargestellte Beschichtungsvorrichtung besteht aus einem beheiztem Zylinder 17, einer Abrollvorrichtung 18 für die
Schutzfolie 23, einer ersten Beschichtungswalze
19, einer Abrollvorrichtung 20 für die Gewebebahn
4, einer zweiten Beschichtungswalze 21 und einer
Abführvorrichtung 22 mit einem nicht dargestellten
Vorschub. Zwischen den Beschichtungswalzen 19 und
21 befindet sich die Antrocknungsstrecke 24, zwischen der Beschichtungswalze 21 und der Abführvorrichtung 22 die Trocknungsstrecke 25.
Die Beheizung des Zylinders 17 ist so ausgelegt,
dass Temperaturen von 40° C nicht überschritten
werden, um die sich auf dem Zylinder 17 bildende
Kopierschicht aus lichtempfindlicher Emulsion oder
Lösung nicht zu schädigen.
Zur Beschichtung wird von der Folienabrollvorrichtung 18 die Schutzfolie 23 geringster Dicke, die
vorzugsweise aus Polyester besteht, auf den Zylinder 17 geführt und mit der Beschichtungswalze 19,
die gegen die Laufrichtung des Zylinders 17 dreht,
in vorbestimmter Dicke mit einer ersten Emulsionsschicht beschichtet. Bei der Beschichtung ist hinsichtlich der endgültigen Dicke der Kopierschicht
zu beachten, dass die Nassfilmstärke unter Berücksichtigung des Feststoffanteils der Emulsion ein
Mehrfaches der gewünschten Kopierschichtdicke sein muss, wie in Fig. 5 dargestellt. Um eine Kopierschichtdicke von 8 bis 40 my zu erzielen, ist deshalb unter Berücksichtigung eines Feststoffanteiles von ca 30 % der Emulsion ein Nassfilm von 30
bis 150 my aufzutragen.

Sodann wird die Gewebebahn 4 von der Abrollvorrichtung 20 an den Zylinder 17 geführt. Dabei ist
zu beachten, dass die Spannung der Gewebebahn gering gehalten wird, um ein zu tiefes Eindringen in
die antrocknende Kopierschicht zu vermeiden. Mittels der Beschichtungswalze 21 ( Fig. 6 ) wird
sodann auf die Rückseite der Gewebebahn 4 eine
zweite Schicht der Emulsion aufgetragen, die sich
mit der ersten Schicht durch die Öffnungen der
Gewebebahn 4 verbindet. Der Verbund aus der
Schutzfolie 23, der Gewebebahn 4 und den Emulsionsschichten wird sodann im Verlauf der Trocknungsstrecke 25 vollständig getrocknet ( Fig. 7 )
und über die Abführvorrichtung der weiteren Verarbeitung zugeführt.

Nach einem weiteren Ausführungsbeispiel wird die
zweite Emulsionsschicht mit der Dosiervorrichtung
26 zwischen der ersten Schicht und der Gewebebahn
4 aufgetragen, wobei die Emulsion von der Innenseite her durch die Öffnungen der Gewebebahn 4
gepresst wird. Dies hat den Vorteil, die Entgasung
der Gewebebahn 4 besser zu gewährleisten. Die anschliessende Dosierwalze 21 wird in diesem Fall
lediglich dazu verwendet, überschüssige Emulsion
von der Rückseite der Gewebebahn 4 zu entfernen
und die Schicht auf der Rückseite zu glätten.

Nach einem weiteren Ausführungsbeispiel kann auf
das Auftragen einer zweiten Emulsionsschicht ganz verzichtet werden. Die auf der Antrocknungsstrecke 24 weitgehend getrocknete erste Emulsionsschicht wird in diesem Falle von der Dosierwalze 21 lediglich mit Wasser oder Lösungsmittel benetzt, um die Schicht oberflächlich anzulösen und eine ausreichende Verbindung mit der Gewebebahn 4 zu erzielen.

Der Aufbau der Siebdruckschablone wird durch den Verwendungszweck bestimmt, nämlich die Dicke der herzustellenden Siebdruckfarbschicht und die Auflösung des Druckbildes.

Die Menge des Farbauftrages bestimmt sich durch die Farbmenge, die sich in den Sieböffnungen befindet. Diese Farbmenge wird durch die Höhe der Sieböffnungen, also im wesentlichen durch die Dicke der Siebdruckschablone bestimmt.

Es hat sich herausgestellt, dass zum Erzielen eines Vollton-Druckes die Kopierschicht möglichst dick und die vernickelte Gewebeschicht grossmaschig und möglichst hoch sein sollte. Die Höhe kann durch eine entsprechend starke Vernickelung der Gewebebahn erzielt werden.

Zum Erzielen eines Druckes mit hoher Auflösung ist es dagegen vorteilhaft, mit einer dünnen Kopierschicht auf einem engmaschigen Gewebe mit geringer, lediglich der Verfestigung des Webverbandes dienender Vernickelung zu arbeiten.

Erfindungsgemäss werden folgende Parameter angewandt:

Gewebe : 250 bis 500 mesh = 100 bis 200 Fäden/cm.

Drahtstärke: 5 bis 50 my.

Nickelschicht: 2 bis 20 my.

Für die Bestimmung der Farbschichtdicke wird –

abhängig von der zu verwendenden Farbe - die eineinhalb- bis fünffache Tiefe der Sieböffnung
( Näpfchentiefe ) berechnet. Die Entleerung der
Näpfchen ist erfahrungsgemäss auf 80 bis 90 % beschränkt. Die Dicke des Chromstahlgewebes beträgt
etwa bis zum 2 1/2 fachen der Drahtstärke, da die
Drähte um Leinenverbund je nach ihrer Stärke und
der Maschenweite nicht unmittelbar aufeinander
liegen.
Die Sieböffnungsfläche beträgt bei Siebschablonen
nach obigen Parametern 5 bis 40 % der Gesamtsiebfläche.

Die Ausgestaltung von Siebschablonen für unterschiedliche Verwendungsfälle wird an den nachfolgenden Ausführungsbeispielen weiter erläutert:

Aufgabe 1: Brillianter Flächendruck ( Gleichmässiger Volltondruck ) mit 30 my U.V.- Farbschicht
( Nass   Trocken ).
Lösung 1:
Maschenweite: 250/inch = 100/ cm.
Drahtstärke: 36 my.
Nickelschicht: 6 - 8 my.
Kopierschicht: 20 my.
Schablonendicke: 95 - 100 my.
Sieböffnung: 35 %.
Bei 80 bis 90 prozentiger Näpfchenentleerung ergibt dies eine Farbschicht von 20 bis 30 my.

Aufgabe 2: Dünne Farbschicht mit hoher Auflösung.

Lösung 2:

Maschenweite: 500/ inch = 200/ cm.

Drahtstärke: 20 my.

Nickelschicht: 6 - 8 my.

Kopierschicht: 10 my.

Schablonendicke: 65 - 70 my.

Sieböffnung: 8 - 10 %.

Hier spielt die Schablonendicke für die Farbschichtdicke praktisch keine Rolle, sondern lediglich die Dicke der Kopierschicht. Bei 80 % Näpfchenentleerung wird also eine Auflösung von 50 bis
70 my, also Durchmesser von Punkt oder Breite einer Linie, und eine Farbpunkthöhe von 6 bis 8 my
erzielt.

Eine Siebdruckschablone entsprechend vorstehendem
Beispiel erlaubt einen an Buchdruckqualität heranreichenden Rasterdruck im 54er Raster mit 10 bis
90 prozentiger Farbdeckung, der mit den bekannten
Siebdruckverfahren nicht erzielt werden kann. Dies
beruht einerseits auf der möglichen Verkleinerung
der Sieböffnungen durch die Vernickelung, andererseits auf der Kantenschärfe, die durch die ebene
Kopierschicht erzielt wird. Bei den herkömmlichen
Beschichtungsverfahren folgt die Oberfläche der
Kopierschicht den Wellen der Drähte des Gewebes,
wodurch im Druckbild der für den konventionellen
Siebdruck charakteristische Sägezahn entsteht.

0182195

Ferd. Rüesch AG
St. Gallen/ Schweiz

<u>Patentansprüche:</u>

1. Verfahren zum Herstellen von fotochemisch beschichteten Siebdruckgeweben zum Herstellen von
Siebdruckzylindern, bestehend aus einem Chromstahldrahtgewebe, dadurch gekennzeichnet, dass das
Chromstahldrahtgewebe elektrolytisch, chemisch
oder durch Vakuumbedampfung mit Nickel beschichtet
wird und auf einer Seite des vernickelten Chromstahldrahtgewebes eine ebene, aus einer oder mehreren Sichten aus lichtempfindlicher Emulsion oder
Lösung bestehende Kopierschicht aufgebracht wird.

2. Verfahren nach Anspruch 1, dadurch gekennzeichnet, dass das Chromstahldrahtgewebe in Bahnform
endlos kontinuierlich in einem elektrolytischen
Tauchbad vernickelt wird, wobei die Chromstahlgewebebahn als Kathode verwendet wird.

3. Verfahren gemäss vorangehenden Ansprüchen, dadurch gekennzeichnet, dass ein Chromstahldrahtgewebe in Leinenbindung mit einer Mesh-Zahl von 250
bis 500 und einer Drahtstärke von 5 bis 50 my verwendet wird.

4. Verfahren nach vorangehenden Ansprüchen, dadurch gekennzeichnet, dass auf das Chromstahldrahtgewebe eine Nickelbeschichtung von 2 bis
20 my aufgebracht wird.

5. Verfahren gemäss Anspruch 1, dadurch gekennzeichnet, dass die vernickelte Chromstahlgewebebahn kontinuierlich mit einer oder mehreren Schichten einer lichtempfindlichen Emulsion oder Lösung beschichtet wird.

6. Verfahren gemäss Anspruch 5, dadurch gekennzeichnet, dass zur Bildung einer ebenen Kopierschicht lichtempfindliche Emulsion auf eine ebene, bewegte geheizte Fläche aufgetragen wird, während des Trocknungsvorganges der Emulsion die vernickelte Chromstahlgewebebahn auf die Rückseite der Kopierschicht geführt und durch Aufbringen einer weiteren Emulsionsschicht mit der Kopierschicht verbunden wird.

7. Verfahren gemäss Ansprüchen 5 und 6, dadurch gekennzeichnet, dass die zweite Emulsions- oder Lösungsschicht während dem Zuführen der vernickelten Chromstahlgewebebahn zwischen der Kopierschicht und der Gewebebahn aufgebracht wird.

8. Verfahren gemäss Anspruch 5, dadurch gekennzeichnet, dass nach dem Antrocknen der Kopierschicht und dem Zuführen der vernickelten Chromstahlgewebebahn die Kopierschicht mit Wasser oder Lösungsmittel benetzt wird.

9. Verfahren gemäss vorangehenden Ansprüchen, dadurch gekennzeichnet, dass zur Bildung einer ebenen Kopierschicht lichtempfindliche Emulsion oder Lösung auf eine Schutzfolie aufgetragen wird, die über eine ebene, geheizte Fläche geführt wird.

10. Verfahren gemäss vorangehenden Ansprüchen, dadurch gekennzeichnet, dass auf die vernickelte Chromstahlgewebebahn eine Kopierschicht von 5 bis 80 my Trockendicke aufgebracht wird.

11. Verfahren gemäss Anspruch 5, dadurch gekennzeichnet, dass die vernickelte Chromstahlgewebebahn mit einer auf einer Folie aufgetragenen, trockenen Kopierschicht durch Aktivieren der Kopierschicht oder mittels einer lichtempfindlichen Emulsion oder Lösung verbunden wird.

12. Vorrichtung zum kontinuierlichen Vernickeln von Chromstahlgewebebahnen (4) gemäss Anspruch 1, bestehend aus einer Abrollvorrichtung (5), mehreren Tauchbädern (6,7) zum Reinigen und Entfetten der Chromstahlgewebebahn (4), einem elektrolytischen Tauchbad (12) und einem Vorschub (15), gekennzeichnet durch eine negativ gepolte Kontaktwalze (8) und einen in das elektrolytische Tauchbad (12) eintauchenden, nicht leitenden Zylinder (11).

13. Vorrichtung gemäss Anspruch 12, dadurch gekennzeichnet, dass der Zylinder (11) in dem Tauchbad (12) vertikal verschiebbar angeordnet ist.

14. Vorrichtung gemäss Anspruch 12, dadurch gekennzeichnet, dass der Zylinder (11) einen möglichst grossen Durchmesser aufweist.

0182195

15. Vorrichtung gemäss Anspruch 12, dadurch gekennzeichnet, dass die nicht leitende Oberfläche
des Zylinders (11) poliert ist.

16. Vorrichtung gemäss Anspruch 12, dadurch gekennzeichnet, dass vor dem elektrolytischen Tauchbad (12) eine Breitstreckvorrichtung (9) angeordnet ist.

17. Vorrichtung gemäss Anspruch 16, dadurch gekennzeichnet, dass die Breitstreckvorrichtung (9)
aus einer bombierten Walze besteht.

18. Vorrichtung zum Herstellen einer Kopierschicht
(2) auf einer vernickelten Chromstahlgewebebahn
(4) gemäss Anspruch 1, gekennzeichnet durch einen
oder mehrere geheizte Zylinder, Mittel zum Auftragen einer lichtempfindlichen Emulsion auf den oder
die Zylinder und Mittel zum Zuführen der vernikkelten Chromstahlgewebebahn (4) auf die sich bildende Kopierschicht (2).

19. Vorrichtung gemäss Anspruch 18, gekennzeichnet
durch einen geheizten Zylinder (17) grossen Umfangs, um den eine Abrollvorrichtung (18) für eine
Schutzfolie (23) mit oder ohne Kopierschicht (2),
eine Beschichtungsvorrichtung (19), eine Zuführvorrichtung (20) der vernickelten Chromstahlgewebebahn (4), eine zweite Beschichtungsvorrichtung
(21) und eine Abzugsvorrichtung (22) angeordnet
sind.

20. Vorrichtung gemäss Anspruch 19, dadurch gekennzeichnet, dass die zweite Beschichtungsvorrichtung (21) von der ersten Beschichtungsvorrichtung (19) in einem Abstand angeordnet ist, der das Antrocknen der ersten Emulsionsschicht erlaubt.

21. Vorrichtung gemäss Anspruch 18, dadurch gekennzeichnet, dass die zweite Beschichtungsvorrichtung (26) vor der Zuführvorrichtung der Chromstahlgewebebahn (4) angeordnet ist.

22. Vorrichtung gemäss Anspruch 21, dadurch gekennzeichnet, dass nach der Zuführvorrichtung (20) eine Kalandrierwalze (21) angeordnet ist.

23. Vorrichtung gemäss Anspruch 18, dadurch gekennzeichnet, dass nach der Beschichtungs- (26) und Zuführvorrichtung (20) eine Benetzungsvorrichtung (21) angeordnet ist.

FIG.1

FIG.2

FIG.3

FIG. 4

FIG. 5

FIG. 6

FIG. 7